# EUROPEAN PATENT APPLICATION

(11) **EP 1 548 811 A2**
(43) Date of publication of application: **29.06.2005**
(21) Application number: 04029549.5
(22) Date of filing: 14.12.2004
(51) Int. Cl.: H01L 21/306, H01L 21/762

(54) **Member which includes porous silicon region, and method of manufacturing member which contains silicon**

(30) Priority: 22.12.2003 JP 2003425827
(71) Applicant: CANON KABUSHIKI KAISHA, Ohta-ku, Tokyo (JP)
(72) Inventor: Ikeda, Hajime Canon Kabushiki Kaisha, Tokyo (JP); Sakaguchi, Kiyofumi Canon Kabushiki Kaisha, Tokyo (JP); Sato, Nobuhiko Canon Kabushiki Kaisha, Tokyo (JP)
(74) Representative: Leson, Thomas Johannes Alois, Dipl.-Ing.

(57) **Abstract**

A technique capable of forming a high-quality nonporous layer with little defects is provided. When an average pore size and pore density are defined as D (nm) and N (pores/cm²), respectively, a silicon wafer is anodized to satisfy 0 < N ≦ 1.9 x 10¹² and 0.235 nm ≦ D < 91 nm to form a porous silicon region in the region near the upper surface of the porous silicon region.

## Description

### FIELD OF THE INVENTION

The present invention relates to a member which includes a porous silicon region, and a method of manufacturing a member which contains silicon, suitably applied for, e.g., the manufacture of an SOI substrate.

### BACKGROUND OF THE INVENTION

Application fields of porous silicon as a porous member include, e.g., the manufacture of an SOI (Silicon On Insulator or Semiconductor On Insulator) substrate. For example, Japanese Patent Laid-Open No. 5-21338 discloses a method of manufacturing the SOI substrate using porous silicon. In the SOI substrate manufacturing method disclosed in Japanese Patent Laid-Open No. 5-21338, for example, (a) a single-crystal silicon wafer is anodized in a solution containing hydrofluoric acid to form a porous silicon layer on an upper surface, (b) a single-crystal silicon layer is formed on the upper surface of the porous silicon layer by epitaxial growth, (c) the first substrate including the single-crystal silicon layer is bonded to the second substrate to prepare a bonded substrate stack such that an insulator is located on the single-crystal silicon layer, and (d) a region from the back surface of the first substrate to the porous silicon layer is removed from the bonded substrate stack.

Note that the porous silicon layer is used as an underlayer for forming the single-crystal silicon layer to be transferred from the first substrate to the second substrate, and also as a separation layer for dividing the bonded substrate stack.

In Japanese Patent Laid-Open No. 2001-168308, a technique for forming a porous layer having a multilayered structure is disclosed. More specifically, in Japanese Patent Laid-Open No. 2001-168308, the first porous layer with the first porosity, and the second porous layer with the second porosity are formed from the upper surface side of the substrate, a 5-µm thick first porous layer is formed, and the first porosity is preferably 10% to 30%.

In the initial stage of the epitaxial growth step of forming the single-crystal silicon layer on the upper surface of the porous silicon layer, a pore in a region near the upper surface of the porous silicon layer is buried. In this burring process, an SFD (Stacking Fault Defect) can be generated. In Japanese Patent Laid-Open No. 2001-168308, the preferable porosity (first porosity) of the first porous layer serving as the underlayer for forming the single-crystal silicon layer is 10% to 30%, and the thickness of the first porous layer is, e.g., 5 µm. However, in order to reduce the number of the SFDs, the evaluation of the porosity in the region with such thickness is not enough, because the porosity in the region from the upper surface to a depth of several µm is not related to the number of the SFDs.

### SUMMARY OF THE INVENTION

The present invention has been made on the basis of the above idea, and has as its object to provide a technique which can form a high-quality nonporous layer with little defects.

According to a first aspect of the present invention, there is provided a member which includes a porous silicon region, wherein an average pore size D (nm) and pore density N (pores/cm²) satisfy 0 < N ≦ D x 1.9 x 10¹², and 0.235 nm ≦ D < 91 nm in the region near an upper surface of the porous silicon region.

Preferably, according to an embodiment of the present invention, a structure which does not satisfy the condition is included on a lower side of a region near the upper surface, or a region with a higher porosity than the porosity which satisfies the condition is formed on the lower side of the region near the upper surface.

Preferably, according to an embodiment of the present invention, the member includes a silicon layer which is adjacent to the upper surface of the porous silicon region.

In the second aspect of the present invention, there is provided a method of manufacturing a member which contains silicon, comprises a high-resistance layer forming step of forming a high-resistance layer on an upper surface of a silicon substrate, which has a higher resistance than a region located inside the silicon substrate, and an anodizing step of anodizing the silicon substrate on which the high-resistance layer is formed to form a porous silicon region, wherein the high-resistance layer forming step and the anodizing step are executed such that an average pore size D (nm) and pore density N (pores/cm²) satisfy 0 < N ≦ D x 1.9 x 10¹², and 0.235 nm ≦ D < 91 nm.

Preferably, according to an embodiment of the present invention, the region near the upper surface is a region at an arbitral depth of less than 35 nm from the upper surface.

Preferably, according to an embodiment of the present invention, the high-resistance layer forming step includes a step of forming an undoped layer in a surface region of the silicon substrate, or a step of forming a doped layer which is doped more lightly than the silicon substrate.

Preferably, according to an embodiment of the present invention, the manufacturing method further comprises a sealing step of sealing pores formed in the surface region of the porous silicon layer by annealing in a non-oxidizing atmosphere the substrate on which the porous silicon region is formed. The manufacturing method can further comprise a silicon layer forming step of forming a nonporous silicon layer on the upper surface of the silicon substrate after the sealing step. The manufacturing method can further include a bonding step of bonding the nonporous silicon layer to another substrate through an insulating layer to prepare a bonded substrate stack, and a dividing step of dividing the bonded substrate stack by using the porous silicon layer. Alternatively, the manufacturing method can further include, without the above silicon layer forming step, a bonding step of bonding the porous silicon layer formed in the sealing step to another substrate through an insulating layer to prepare a bonded substrate stack, and a dividing step of dividing the bonded substrate stack by using the porous silicon layer.

In the present invention, for example, the high-quality nonporous layer with little defects can be formed.

Other features and advantages of the present invention will be apparent from the following description taken in conjunction with the accompanying drawings, in which like reference characters designate the same or similar parts throughout the figures thereof.

### BRIEF DESCRIPTION OF THE DRAWINGS

The accompanying drawings, which are incorporated in and constitute a part of the specification, illustrate embodiments of the invention and, together with the description, serve to explain the principles of the invention.
Fig. 1 is a graph showing the relationship between the average pore size, pore density, and porosity (numerically expressed) of a porous silicon layer;
Fig. 2 is a graph showing the relationship between the average pore size, pore density, and SFD density (numerically expressed) of the porous silicon layer;
Fig. 3 is a view for explaining a mechanism in which the porosity is changed in the depth direction by anodizing;
Fig. 4 is a graph showing a result obtained by measuring the distribution of boron concentration in the depth direction by an SIMS, in a substrate stack prepared by forming an undoped silicon layer on a boron-doped p⁺-type silicon substrate having a resistance of 16 mΩcm;
Fig. 5 is a table showing a result obtained by, in a chemical solution containing 42.5% of hydrofluoric acid, 9.2% of isopropyl alcohol, and water, supplying the current with a current density of 16.3 mA/cm² to the substrate serving as an anode which is a sample to obtain the table shown in Fig. 4, evaluating a region near the upper surface of the porous silicon layer formed by anodizing, and analyzing the evaluation;
Fig. 6 is a view schematically showing an uppermost layer, low-porosity layer, and high-porosity layer included in the porous silicon layer;
Fig. 7 is a graph showing a result obtained by evaluating the SFDs formed by forming a single-crystal silicon layer on the upper surface of the porous silicon layer by epitaxial growth;
Figs. 8A to 8G are views showing a method of manufacturing an SOI substrate according to the preferable embodiment of the present invention; and
Fig. 9 is a table showing evaluation results according to the first to fourth embodiments of the present invention.

### DETAILED DESCRIPTION OF THE PREFERRED EMBODIMENTS

Most preferable embodiments of the present invention will be described below.

A porous silicon layer (porous silicon region) serving as an underlayer for forming a semiconductor layer such as a single-crystal silicon layer desirably has a structure wherein pores exposed to an upper surface are easily sealed. The pores may be sealed in the initial stage of the growth step of forming the semiconductor layer such as the single-crystal silicon layer on the porous silicon layer. However, the pores are preferably sealed by annealing prior to the semiconductor layer growth step. A high-quality semiconductor layer can be formed on the porous silicon layer by annealing and sealing the pores. Therefore, a porous structure wherein the pores can be easily sealed by annealing will be described below. Note that in the porous structure wherein the pores can be easily sealed by annealing, the pores can also easily be sealed by the semiconductor layer growth.

In the entire region of the porous layer, a region near the upper surface (e.g., a region from the upper surface to the depth of 10 nm) affects the number of the SFDs in the single-crystal silicon layer formed on the porous layer. Therefore, the number of the SFDs can be reduced by optimizing the porous structure of the region near the upper surface. Note that in the manufacture of the SOI substrate, the porous silicon layer must be removed from the second substrate (support substrate) by etching after dividing the bonded substrate stack. Hence, the facilitation of removing the porous silicon layer by etching need to be considered. In consideration of removing the porous layer by etching, the porosity of the porous silicon layer in the region to be removed by etching is preferably, e.g., 10% to 60%.

An example of the preferable porous structure will be described below. The porous silicon layers respectively having various pore densities, pore sizes, and porosities are annealed. The porous silicon layer is annealed in order to seal the pores. More specifically, in hydrogen atmosphere at 80 Torr, the porous silicon layer is heated from the ambient temperature to 950°C for 100 sec. After that, the temperature is held for 2 sec, and then reduced to the ambient temperature. At this time, a sample with pores which are sealed on the upper surface of the porous silicon layer, and another sample with pores which are not sealed are confirmed by observation with an SEM (Scanning Electron Microscope). Next, the single-crystal silicon layer is formed on the porous silicon layer by epitaxial growth so as to have a thickness of 4 µm. In the single-crystal silicon layer formed on the pores which are not sealed, the SFD is generated starting from the pores.

According to an experiment, the relationship between the degree of sealing the pores observed with the SEM and the density of the generated SFDs is confirmed. The density of the SFDs is more quantitative than the degree of sealing observed with the SEM. Hence, the density of the SFDs is preferably used as an index which evaluates the degree of sealing. As described above, the degree of sealing executed by annealing can be quantitatively evaluated by confirming the relationship between the pore density, pore size, and porosity, and the SFD.

In this experiment, in the anodizing process to form the porous silicon layer, a boron-doped p⁺-type silicon wafer having a resistivity of 16 mΩcm is dipped into a chemical solution of 22.5°C containing 42.5% of hydrofluoric acid (HF), 9.2% of isopropyl alcohol (IPA), and water. A current with a current density of 16.3 mA/cm² is supplied to the silicon wafer serving as an anode. The porous silicon layer having pores with large diameters is obtained by repeating oxidization with ozonic water and etching with dilute hydrofluoric acid (HF) on the anodized porous silicon layer. The porous silicon layer with a high pore density is obtained by anodizing the p⁻-type silicon wafer which is doped more lightly with born than that of the above-described p⁺-type silicon wafer with the resistivity of 16 mΩcm. Note that when anodizing the p⁻-type silicon wafer, the pore density of the p⁻-type silicon wafer becomes higher than that of the p⁺-type silicon wafer.

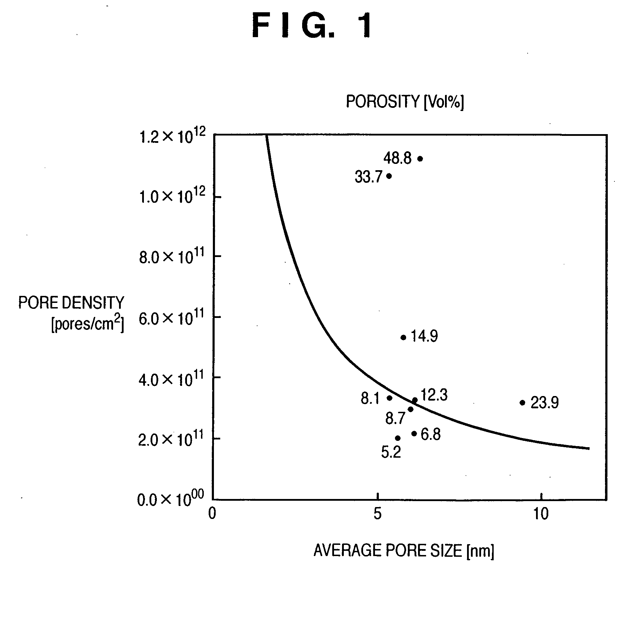

Fig. 1 shows the relationship between the average pore size, pore density, and porosity of porous silicon formed in the above experiment. The numerical values in Fig. 1 are obtained by observing the surface of porous silicon in the range of 100 nm x 150 nm with an SEM and quantitatively measuring the surface. The average pore size is plotted along the abscissa, while the pore density is plotted along the ordinate. The plotted points exhibit the evaluation results of the samples. The numerical value added to each point represents the porosity, i.e., the ratio of the pore volume to the overall volume of the corresponding evaluation region. In principle, the product of the pore size and the pore density is proportional to the porosity. In practice, however, since the frequency distribution of the pore sizes is not the normal distribution, the products must be adjusted based on not only simple integration values but also actual measurement values. The curve in Fig. 1 represents a porosity of 10% calculated on the basis of the pore size and pore density. The average pore size D [nm] and pore density N [pores/cm²] satisfy N = D x 1.9 x 10¹².

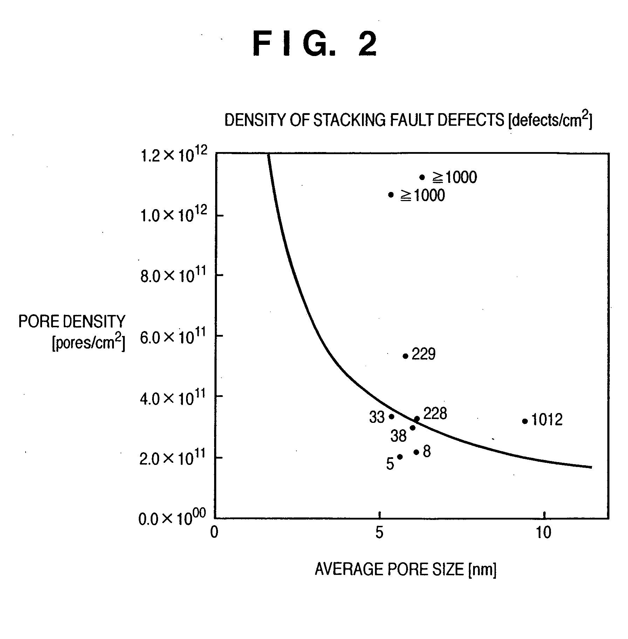

Fig. 2 is same as Fig. 1 except that the densities of the SFDs are added as numerical values. As compared with Fig. 1, the region which represents the porosity of less than 10% (region on the left side of the curve) corresponds to the region which represents the density of the SFDs of 100 defects/cm² or less. Therefore, the porous structure wherein the pores can be easily sealed by annealing is determined to be the low-porosity structure when the pore structure has the small pore size or the low pore density. More specifically, the average pore size D [nm] and pore density N (pores/cm²) satisfy N ≦ D x 1.9 x 10¹². Note that since the region wherein no pore is formed is not the porous structure, N > 0. Also, experimentally, the pore with a diameter of more than 200 nm cannot be sealed only by annealing. In the experiment to obtain the above data, the maximum pore size is less than 2.2 times the average pore size. Hence, in order to obtain the maximum pore size of less than 20 nm, the average pore size must be less than 91 nm. Also, the pore size cannot be smaller than the occupation diameter of one atom. Therefore, more accuracy, in the range defined by 0 < N≦ D x 1.9 x 10¹², 0.235 nm ≦ D < 91 nm, the porous structure wherein the pores are easily sealed by annealing, i.e., the preferable porous structure can be implemented.

When applying for the manufacture of an SOI substrate, the above-described porous structure should be formed near the upper surface, but not in the porous silicon layer. When the pores are easily sealed inside of the porous silicon layer (region deeper than the region near the upper surface), the pores in the porous silicon layer are also sealed by annealing or epitaxial growth, thereby interfering with the dividing or etching process thereafter. Therefore, in the application of the manufacture of the SOI substrate, the structure is required, wherein the pores are easily sealed in the region near the upper surface of the porous silicon layer, and the pores are not easily sealed in the porous silicon layer (especially, region from the lower end of the region near the upper surface to the separation surface). Note that, for example, the region near the upper surface is the region from the upper surface to an arbitral depth of several to several ten nm (e.g., region from the upper surface to the depth of 35 nm).

As a preferable method of forming the porous structure wherein the pores are easily sealed in the region near the upper surface of the substrate, for example, on the upper surface of the impurity-doped substrate, an undoped layer or a doped layer which is doped more lightly than that of the substrate is formed, and then the substrate is anodized. For example, when anodizing the substrate after forming the p⁻-type silicon layer on the upper surface of the p⁺-type silicon substrate by epitaxial growth, the low-porosity layer is generated in the region between an interface and the upper surface of the substrate wherein the resistivity changes, i.e., inside of the interface. Furthermore, when a p⁻-type silicon layer is extremely thin, a low-porosity layer is formed near the upper surface of the substrate. Such distribution of the porosities is described in Originofa Parasitic surface film on p⁺ type porous silicon, V. Chamard, G. Dolinoand, and F. Muller, Journal of Applied Physics.

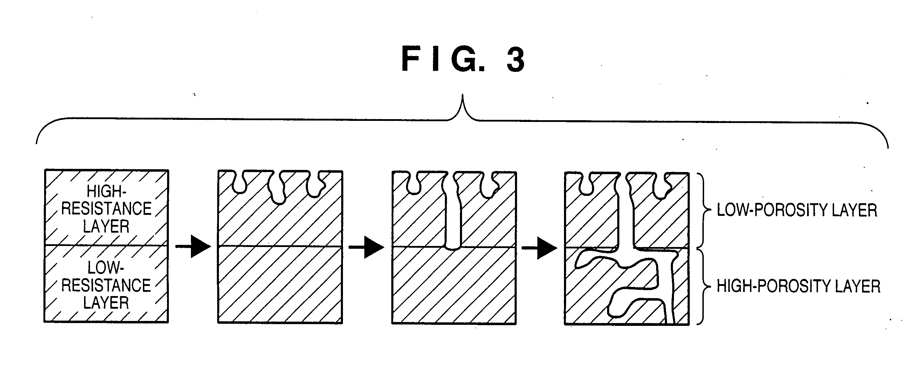

With reference to Fig. 3, a mechanism wherein the porosity changes in a depth direction by anodizing will be described. When forming an undoped silicon layer on the upper surface of a p⁺-type silicon substrate by epitaxial growth, boron is diffused from the substrate, and an epitaxial layer changes to a p⁻-type silicon layer. The p⁻-type silicon layer has a higher resistivity than that of the p⁺-type silicon layer. Since the layer is anodized by growing pores in the upper surface of the substrate, the p⁻-type silicon is anodized near the upper surface of the substrate to form many pores. The pore which quickly grows of the many pores reaches first the low-resistance region (i.e., p⁺-type region). Since the current concentrates to the pore, the pores around the pore (pore which reaches first the low-resistance region) stop growing. Thus, a low-porosity layer can be formed near the upper surface.

The high-resistance layer can be formed by forming an undoped silicon layer or lightly-doped silicon layer by epitaxial growth as described above. Also, on the basis of the anodizing condition in detail, the thickness of the low-porosity layer is proportional to that of the high-resistance layer. When the thickness of the high-resistance layer is less than 100 nm, experimentally, the region from the surface to the depth of 0.3 T + 11.9 [nm] is the low-porosity layer with respect to the T-nm thick high-porosity layer. Therefore, the thickness of the low-porosity layer can be controlled on the basis of this equation.

Note that in the above mechanism, the layer having the high pore density is always formed by anodizing the p⁻-type silicon layer on the uppermost surface of the substrate stack. If the high-resistance layer is thin, however, a pore can reach the low-resistance layer in the initial state of anodizing. Hence, the upper surface layer with the high pore density (to be referred to as an uppermost layer hereinafter) is not formed actually. By the observation with the SEM and X-ray reflectivity measurement, the present inventors confirm that the uppermost layer is not actually formed when the sum of the thicknesses of the uppermost layer and the low-porosity layer is less than 35 nm in the above anodizing condition. That is, the uppermost surface of the substrate stack becomes flat by designing the process such that the thickness of the low-porosity layer is less than 35 nm.

Note that the method of forming the high-resistance layer on the upper surface of the substrate stack is not limited to the method of forming the undoped or lightly doped silicon layer by epitaxial growth. For example, a p-type substrate stack can be counter-doped, i.e., an impurity having an n-type conductivity can be doped. In this case, hydrogen can be used as the n-type impurity. In order to diffuse hydrogen in the silicon layer, the method of dipping the substrate stack in an alkaline solution is generally known.

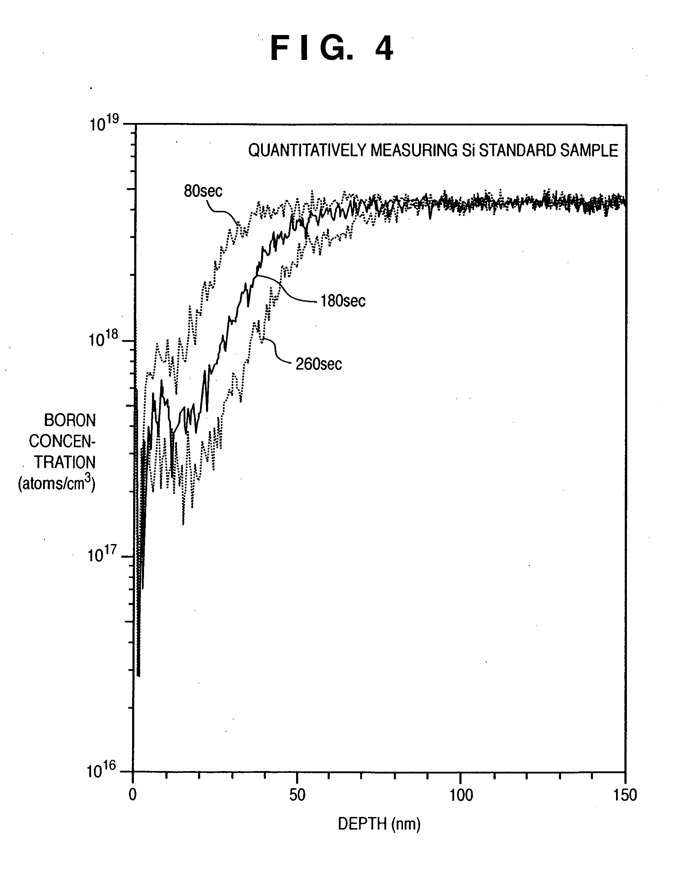

Fig. 4 is a graph showing a result obtained by measuring the distribution of boron concentration in the depth direction by an SIMS, in a substrate stack prepared by forming an undoped silicon layer on a boron-doped p⁺-type silicon substrate having a resistivity of 16 mΩcm. Fig. 4 shows three curves which respectively represent the results obtained when the epitaxial growth time is set to 80, 180, and 260 sec. The longer the epitaxial growth-time, the thicker the layer which is doped lightly with boron (i.e., high-resistance layer). Note that in general, since a surface contamination affects the SIMS measurement, the reliability of the measurement on the uppermost surface is poor. In this measurement, the numerical value of the region at the depth of more than 10 nm is effective.

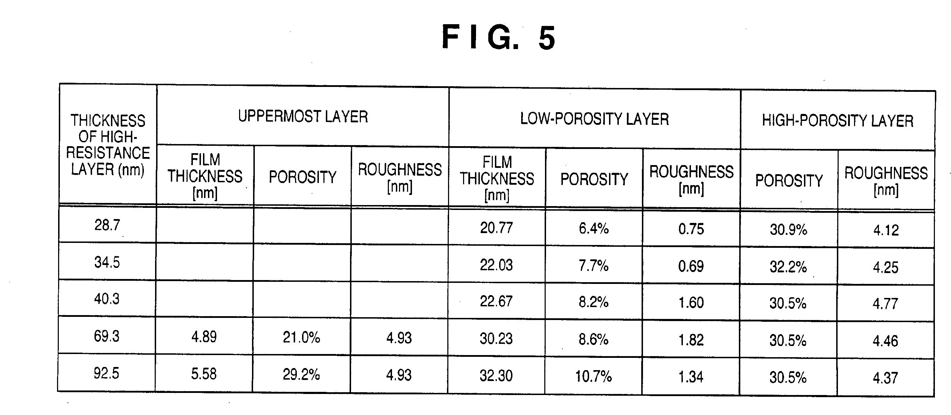

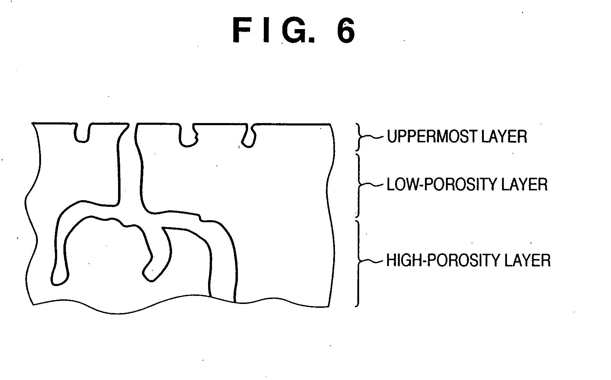

Fig. 5 is a table showing a result obtained by, in a chemical solution containing 42.5% of hydrofluoric acid, 9.2% of isopropyl alcohol, and water, supplying a current with a current density of 16.3 mA/cm² to the substrate serving as an anode which is a sample to obtain the table shown in Fig. 4, evaluating the region near the upper surface of the porous silicon layer formed by anodizing, and analyzing the evaluation. Fig. 5 shows, from the left column, the thickness of the high-resistance layer, the thickness, porosity, and roughness (result obtained by evaluating the roughness of the uppermost surface with Rms) of the uppermost layer, the thickness, porosity, and roughness (result obtained by evaluating the roughness of the interface between the uppermost layer and low-porosity layer with Rms) of the low-porosity layer, and the porosity and roughness (result obtained by evaluating the roughness of the interface between the low-porosity layer and the porous silicon layer with Rms) of the porous silicon layer. Fig. 6 is a view schematically showing the uppermost layer, low-porosity layer, and high-porosity layer. When anodizing the silicon substrate stack having the high-resistance layer (layer with a higher resistance than that located inside the substrate stack) on the upper surface, the uppermost layer, low-porosity layer, and high-porosity layer are formed from the upper surface of the substrate stack. It is known that the uppermost layer has a higher porosity than that of the low-porosity layer below, and that the high-porosity layer has a higher porosity than that of the low-porosity layer above.

As shown in Fig. 5, it is understood that the low-porosity layer which has a lower porosity than that of the high-porosity layer (layer with almost uniform porosity in the substrate) located inside the substrate stack is formed. Also, if the sum of thicknesses of the uppermost layer (if it is formed) and the low-porosity layer is less than 35 nm, the uppermost layer is not observed.

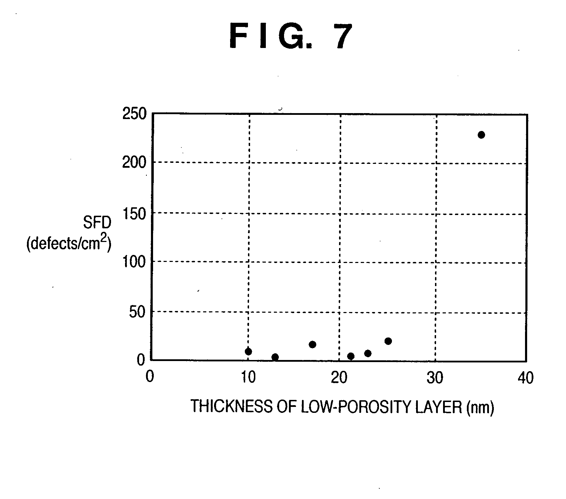

Fig. 7 is a graph showing a result obtained by evaluating the SFDs formed by forming a single-crystal silicon layer on the upper surface of the porous silicon layer by epitaxial growth so as to have a thickness of 4 µm. Fig. 7 shows the number of SFDs after the epitaxial growth step with respect to the thickness of the low-porosity layer (in this case, the sum of the thicknesses of the low-porosity layer and uppermost layer). In Fig. 7, if the thickness of the low-porosity layer is more than 35 nm, the number of SFDs increases. This is because, since the many pores are exposed to the upper surface (uppermost surface), the roughness on the upper surface becomes large after annealing before the epitaxial growth step.

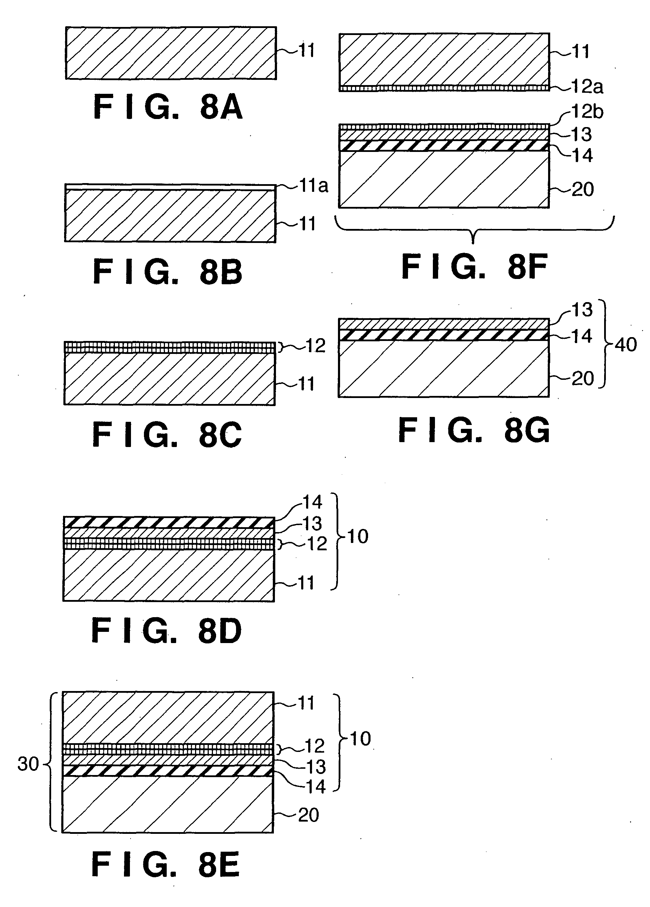

Embodiments of the present invention in which a porous silicon structure or a porous silicon layer is applied to the manufacture of an SOI substrate will be described below. Figs. 8A to 8G are views showing a method of manufacturing the SOI substrate according to the preferable embodiment of the present invention.

In the step shown in Fig. 8A, a silicon substrate 11 such as the p⁺-type silicon substrate (seed substrate) is prepared. In the high-resistance layer forming step in Fig. 8B, for example, the undoped silicon layer or the silicon layer which is doped more lightly than that of a silicon substrate 11 is formed on the upper surface of the silicon substrate 11 by epitaxial growth. Alternatively, as described above, in place of the epitaxial growth step, an impurity having a conductivity type opposite to that of the silicon substrate 11 may be doped. In this high-resistance layer forming step, a high-resistance layer 11a which has a higher resistance than that located inside the silicon substrate 11 is formed on the upper surface of the silicon substrate 11.

In the anodizing step shown in Fig. 8C, the silicon substrate 11 is anodized to form a porous silicon layer 12 on the upper surface. In this porous layer forming step, the porous silicon layer 12 including the uppermost layer, low-porosity layer, and high-porosity layer from the upper surface is formed as schematically shown in Fig. 6. Note that, as described above, the uppermost layer is not formed according to the conditions.

In nonporous layer forming step shown in Fig. 8D, the nonporous semiconductor layer such as a nonporous single-crystal silicon layer 13 is formed on the porous silicon layer 12. The nonporous single-crystal silicon layer 13 can be generally formed by epitaxial growth. After forming the nonporous single-crystal silicon layer 13, an insulating layer such as a silicon oxide insulating layer 14 is preferably formed on the single-crystal silicon layer 13. For example, the silicon oxide insulating layer 14 can be formed by oxidizing the upper surface of the single-crystal silicon layer 13 by thermal oxidation. Note that prior to the formation of the nonporous semiconductor layer 13, the silicon substrate 11 with the upper surface on which the porous silicon layer 12 is formed is preferably annealed to seal the pores in the porous silicon layer 12 in advance. When sealing the pores in the porous silicon layer 12 by annealing to change the upper layer to the nonporous silicon layer with sufficient thickness, the epitaxial growth step of the silicon layer is not needed.

In the bonding step shown in Fig. 8E, a second substrate 20 (handle substrate) is bonded to the insulating layer 14 of a first substrate 10 prepared in the step shown in Fig. 8D, to prepare a bonded substrate stack 30. In this case, for example, the second substrate 20 can employ the silicon substrate, the silicon substrate with the insulating layer on the upper surface, or the insulating substrate such as a glass substrate. Note that when the insulating layer 14 is not formed on the semiconductor layer 13, the second substrate 20 employs the substrate having at least an insulator on the upper surface.

In the dividing step shown in Fig. 8F, the porous silicon layer 12 serves as the separation layer to divide the bonded substrate stack 30 into the two substrates. In this case, the bonded substrate stack 30 can be divided inside the porous silicon layer 12 or at the interface between the porous silicon layer 12 and one of the adjacent two layers. Therefore, the region between the lower surface of the first substrate 10 and the porous silicon layer 12 included in the bonded substrate stack 30 is removed. For example, the dividing step is executed by injecting a fluid into or around the porous silicon layer 12 while rotating the bonded substrate stack 30. This method is the application of a water jet method. In this case, in place of the dividing step, the region between the lower surface of the first substrate 10 and the porous silicon layer 12 included in the bonded substrate stack 30 may be removed by the etching, polishing, or the like.

In the post-process step shown in Fig. 8G, the upper surface of the divided second substrate 20 is etched and/or planarized (e.g., polishing or annealing) to obtain an SOI substrate 40 having the semiconductor layer 13 with a desirable thickness and flatness. In this case, the semiconductor layer 13 is the SOI substrate located on the buried insulating layer 14.

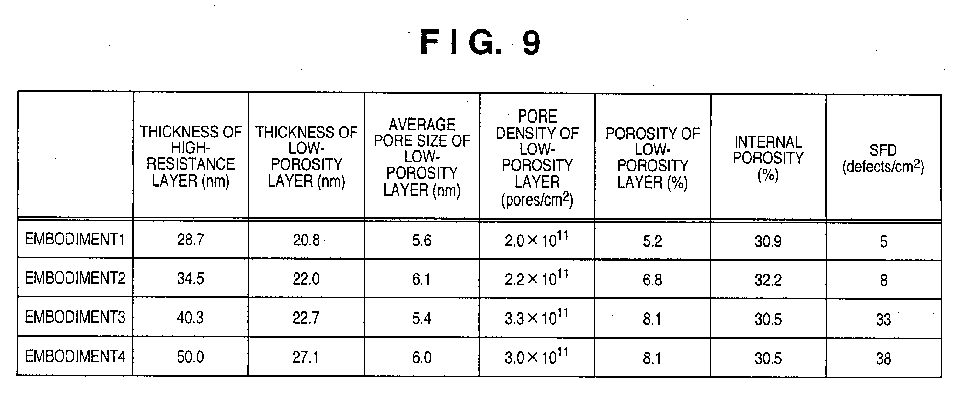

Fig. 9 is a table showing evaluation results according to the first to fourth embodiments of the present invention. An undoped silicon layer is formed on the upper surface of a boron-doped p⁺-type silicon substrate having a resistivity of 16 mΩcm by epitaxial growth to form a high-resistance layer. Note that in the first to fourth embodiments, as shown in Fig. 9, the thicknesses of the formed high-resistance layers are different. The upper surface of the silicon substrate subjected to the epitaxial growth process is rough without a step structure such as a step/terrace structure.

When anodizing this silicon substrate and evaluating it by the X-ray reflectivity measurement, the structure with the low-porosity layer is confirmed. The average pore size, pore density, and porosity of the formed low-porosity layer are evaluated with the SEM. The porosity in the porous silicon layer (high-porosity layer) is evaluated by the X-ray reflectivity measurement.

In a hydrogen atmosphere at 80 Torr, the anodized substrate is heated from the ambient temperature to 950°C for 100 sec, and annealed at 950°C for 2 sec. After that, the silicon layer is formed on this substrate by epitaxial growth, and the density of the SFD is evaluated. In the first to fourth embodiments shown in Fig. 9, it is confirmed that the porous silicon layer with the low-porosity layer is more advantageous than the porous silicon layer without the low-porosity layer which has the density of the SFD of 228 defects/cm².

As many apparently widely different embodiments of the present invention can be made without departing from the spirit and scope thereof, it is to be understood that the invention is not limited to the specific embodiments thereof except as defined in the claims.

A technique capable of forming a high-quality nonporous layer with little defects is provided. When an average pore size and pore density are defined as D (nm) and N (pores/cm²), respectively, a silicon wafer is anodized to satisfy 0 < N≦ 1.9 x 10¹² and 0.235 nm ≦ D < 91 nm to form a porous silicon region in the region near the upper surface of the porous silicon region.

## Claims

1. A member which includes a porous silicon region, wherein:
an average pore size D (nm) and pore density N (pores/cm²) satisfy 0 < N ≦ D x 1.9 x 10¹², and 0.235 nm ≦ D < 91 nm.

2. The member according to claim 1, wherein a structure which does not satisfy the condition is included on a lower side of a region near an upper surface.

3. The member according to claim 1, wherein a region with higher porosity than the porosity which satisfied the condition is formed on the lower side of the region near the upper surface.

4. The member according to claim 1, further comprising a silicon layer is included, which is adjacent to the upper surface of the porous silicon region.

5. A method of manufacturing a member which contains silicon, comprises
a high-resistance layer forming step of forming a high-resistance layer on an upper surface of a silicon substrate, which has a higher resistance than a region located inside the silicon substrate; and
an anodizing step of anodizing the silicon substrate on which the high-resistance layer is formed to form a porous silicon region,
wherein the high-resistance layer forming step and the anodizing step are executed such that an average pore size D (nm) and pore density N (pores/cm²) satisfy 0 < N ≦ D x 1.9 x 10¹², and 0.235 nm ≦ D < 91 nm.

6. The method according to claim 5, wherein the region near the upper surface is a region at an arbitral depth of less than 35 nm from the upper surface.

7. The method according to claim 5, wherein the high-resistance layer forming step includes a step of forming an undoped layer in a surface region of the silicon substrate.

8. The method according to claim 5, wherein the high-resistance layer forming step includes a step of forming a doped layer which is doped more lightly than the silicon substrate.

9. The method according to claim 5, further comprising a sealing step of sealing pores formed in the surface region of the porous silicon layer by annealing in a non-oxidizing atmosphere the substrate on which the porous silicon region is formed.

10. The method according to claim 9, further comprising a silicon layer forming step of forming a nonporous silicon layer on the upper surface of the silicon substrate after the sealing step.

11. The method according to claim 10, further including:
a bonding step of bonding the nonporous silicon layer to another substrate through an insulating layer to prepare a bonded substrate stack; and
a dividing step of dividing the bonded substrate stack by using the porous silicon layer.

12. The method according to claim 9, further including:
a bonding step of bonding the porous silicon layer formed in the sealing step to another substrate through an insulating layer to prepare a bonded substrate stack; and
a dividing step of dividing the bonded substrate stack by using the porous silicon layer.
